(19) Europäisches Patentamt
European Patent Office
Office européen des brevets

(11) Publication number: 0 114 258
A1

(12) EUROPEAN PATENT APPLICATION

(21) Application number: 83111955.7

(22) Date of filing: 29.11.83

(51) Int. Cl.³: H 01 L 23/30
H 01 L 31/02, C 08 L 63/00

(30) Priority: 30.11.82 JP 208397/82
30.11.82 JP 208398/82
23.03.83 JP 47230/83

(43) Date of publication of application:
01.08.84 Bulletin 84/31

(84) Designated Contracting States:
CH DE FR GB LI NL

(71) Applicant: TOKYO SHIBAURA DENKI KABUSHIKI KAISHA
72, Horikawa-cho Saiwai-ku
Kawasaki-shi Kanagawa-ken 210(JP)

(72) Inventor: Onishi, Yasunobu
c/o Tokyo Shibaura Denki K.K. 72, Horikawa-cho
Saiwai-ku Kawasaki-shi Kanagawa-ken(JP)

(72) Inventor: Hayase, Shuzi
c/o Tokyo Shibaura Denki K.K. 72, Horikawa-cho
Saiwai-ku Kawasaki-shi Kanagawa-ken(JP)

(72) Inventor: Suzuki, Shuichi
c/o Tokyo Shibaura Denki K.K. 72, Horikawa-cho
Saiwai-ku Kawasaki-shi Kanagawa-ken(JP)

(72) Inventor: Wada, Moriyasu
c/o Tokyo Shibaura Denki K.K. 72, Horikawa-cho
Saiwai-ku Kawasaki-shi Kanagawa-ken(JP)

(74) Representative: Hansen, Bernd, Dr.rer.nat. et al,
Hoffmann, Eitle & Partner Patentanwälte Arabellastrasse 4
D-8000 München 81(DE)

(54) **Resin encapsulation type photo-semiconductor devices.**

(57) Disclosed is a resin encapsulation type photo-semiconductor device, which comprises a photo-semiconductor element encapsulated with a photopolymerizable composition comprising an epoxy resin, an aluminum compound and a silicon compound capable of forming a silanol group by irradiation with light.

EP 0 114 258 A1

Croydon Printing Company Ltd.

# Resin encapsulation type photo-semiconductor devices

## BACKGROUND OF THE INVENTION

This invention relates to a resin encapsulation type photo-semiconductor device. More particularly, it relates to a resin encapsulation type photo-semiconductor device for which employed is a photocurable epoxy resin composition having an improved curability and giving electric properties suitable for use as an insulating material, a resist material, etc. for a variety of electrical equipments.

The above-mentioned photo-semiconductor device is herein meant generically to be a light-emitting device such as a light-emitting diode, etc., a light-detecting device (or photoelectric transducer) such as a CCD (charge coupled device) image sensor, a phototransistor, etc., or a composite device comprised of the light-emitting device and the light-detecting device, such as a photocoupler, etc.

Heretofore, the above photo-semiconductor devices including the light-emitting device such as light-emitting diode and the other devices, which have

BAD ORIGINAL

been put to practical use for various kinds of indicators, have been manufactured by encapsulating a photo-semiconductor element with a resin. When encapsulating the photo-semiconductor element with a resin, epoxy resin series compositions which are excellent in an electrical property, a water resisting property and a heat resisting property have been used predominantly as encapsulation resins.

Nonetheless, the encapsulation resins conventionally used, which are epoxy resin compositions of thermosetting type, have required ten hours or more to have cured. For this reason, encapsulation methods utilyzing such compositions have been disadvantageous in respect of the productivity.

In recent years, photocurable epoxy resin type composition have been developed for the purpose of minimizing the curing time, saving the heat source and enhancing the productivity. Such resin composition can be roughly classified into the following two types:

One is a composition obtained by modification of an epoxy resin with use of a vinyl group-containing compound such as an acrylic ester having a photopolymerizability, which undergoes photopolymerization through the vinyl group. However, the modified epoxy resin is considerably inferior in the heat resisting property to the epoxy resin itself.

The other is a composition obtained by curing the epoxy resin itself by use of a catalyst of a photodecomposable type. An example of the catalyst used therefor is a complex represented by the following formula:

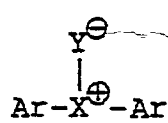

(wherein Ar represents an aromatic group such as a phenyl group; X represents an iodine atom, a sulfur atom, a diazo group, or the like; and Y represents $BF_4$, $PF_6$, $AsF_6$, $SbF_6$ or the like), as disclosed in Macromoleculas, 10, 1307 (1977); Journal of Radiation Curing, 5, 2 (1978); Journal of Polymer Science Polymer Chemistry Edition, 17, 2877 (1979); ditto, 17, 1047 (1979); Journal of Polymer Science Polymer Letters Edition 17, 759 (1979); Specification of Japanese Unexamined Patent Publication (KOKAI) No. 65219/1980; specification of U.S. Patent No. 4,069,054; specification of British Patent No. 1,516,511; specification of British Patent No. 1,518,141; etc.

However, when an epoxy resin is cured by the aid of such a catalyst component, the cured product thus obtained has a good mechanical property and a heat resisting property, whereas the catalyst component remains as an ionic impurity. Therefore, it is feared that the deterioration of electrical insulating property and corrosion phenomenon occur when such a cured product is applied in an electrical equipment.

Thus, the performance of a resultant photo-semiconductor device itself has been liable to become inferior when a resin encapsulation type photo-semiconductor device is manufactured by use of the conventional photocurable epoxy resin type composition.

It is an object of this invention to provide a resin encapsulation type photo-semiconductor device which may eliminate the above-mentioned disadvantage in the prior art device and, at the same time, improve the productivity by employing a photocurable epoxy resin type composition being curable with irradiation of energy rays such as light, ultraviolet rays, X-rays, gamma rays and electron beams, particularly with ultraviolet rays, and

in a shorter time.

As a result of intensive studies made by the present inventors, it was found that the above object can be achieved by using as photocuring catalysts an aluminum compound, and a silicon compound capable of forming a silanol group by irradiation of energy rays (herein meant to include the above-mentioned light, ultraviolet rays, X-rays, gamma rays, electron beams and the like), in combination with the epoxy resin, and optionally by using further a photosensitizer. The invention has thus accomplished.

## SUMMARY OF THE INVENTION

The resin encapsulation type photo-semiconductor device according to this invention is characterized by comprising a photo-semiconductor element (herein meant to include a light-emitting elemenet or a light-detecting element to be used correspondingly in the aforementioned light-emitting divice or light-detecting device) encapsulated with a photopolymerizable composition comprising;

(a) an epoxy resin
(b) an aluminum compound, and
(c) a silicon compound capable of forming a silanol group by irradiation with energy rays.

In this invention, the silicon compound as defined in the above (c) is meant to be i) a silicon compound having a peroxysilyl group, ii) a silicon compound having an α-ketosilyl group or iii) a silicon compound having an o-nitrobenzyloxy group.

Moreover, the photopolymerizable composition in this invention may further contain a photosensitizer.

DETAILED DESCRIPTIONS OF THE INVENTION

The epoxy resin used in this invention is an epoxy compound to be used alone or a mixture of an epoxy compound with one or more compounds selected from the group consisting of an acid anhydride, a phenol series compound and a compound having an ethylenic unsaturated group.

The epoxy compound to be used in this invention constitutes a principal component of the composition of this invention. As the epoxy compound, there may be mentioned monofunctional epoxy compounds or polyfunctional epoxy compounds. Examples of the monofunctional epoxy compounds may include ethylene oxide, propylene oxide, butylene oxide, stylene oxide, phenyl glycidyl ether, butyl glycizyl ether, etc. Examples of the polyfunctional epoxy compounds may include a bisphenol A type epoxy resin; a bisphenol F type epoxy resin; a phenol-novolac type epoxy resin; an alicylic epoxy resin; a heterocyclic ring-containing epoxy resin such as triglycidyl isocyanurate, hydantoin epoxy, or the like; a hydrogenated bisphenol A type epoxy resin; an aliphatic epoxy resin such as propylene glycol diglycidyl ether, pentaerythritol polyglycidyl ether or the like; a glycidyl ester type epoxy resin obtained by the reaction of an aromatic, aliphatic or alicyclic carboxylic acid with epichlorohydrin; a spiro ring-containing epoxy resin; a glycidyl ether type epoxy resin which is a reaction product of an o-allyl-phenol-novolac compound and epichlorohydrin; a glycidyl ether type epoxy resin which is a reaction product of a diallyl bisphenol compound, having an allyl group at the o-position of each of the hydroxyl groups in bisphenol A, and epichlorohydrin; etc. One or more kinds selected from the group consisting of the above may be used optionally.

BAD ORIGINAL

As the phenol series compound to be used by being added to the epoxy compound, there may be mentioned bisphenol series compounds such as bisphenol A, bisphenol F, bisphenol S and the like; and a condensate of phenols such as phenol, cresol, catechol, bisphenol A and the like with formaldehyde; etc.

As the ethylenic compound to be used in this invention, there may be mentioned stylene and derivatives thereof; unsaturated carboxylic acids, unsaturated carboxlates; esters of unsaturated carboxylic acids with aliphatic hydroxyl compounds, aliphatic polyhydroxy compounds, aromatic hydroxyl compounds or aromatic polyhydroxy compounds; polycarboxylic acids containing two or more carboxyl groups; oligoesters obtained by esterification reaction of polyhydroxyl compound containing two or more hydroxyl groups and unsaturated carboxylic acids; etc.

Examples of the unsaturated carboxylic acids may include acrylic acid, methacrylic acid itaconic acid, crotonic acid, isocrotonic acid, maleic acid, etc.

Examples of the aliphatic hydroxyl compounds may include methanol, ethanol, propanol, butanol, etc.

Examples of the aliphatic polyhydroxyl compounds may include dihydric alcohols such as ethylene glycol, triethylene glycol, tetraethylene glycol, tetramethylene glycol, neopentyl glycol, 1,10-decanediol, 1,2-butanediol, 1,3-butanediol and propylene glycol; trihydric alcohols such as trimethylolethane and tetramethylolethane, and a polymer thereof; alcohols containing four or more hydroxyl groups such as pentaerithritol, dipentaerithritol, tripentaerithritol and other polymeric pentaerithritol, saccharides such as sorbitol and D-mannitol; dihydroxycarboxylic acids such as dihydroxymaleic acid, etc.

BAD ORIGINAL

Examples of the aromatic hydroxyl compounds and the aromatic polyhydroxyl compounds may include phenol, hydroquinone, catechol, resorcinol, phloroglucinol, pyrogallol, etc.

Examples of the esters of aliphatic hydroxyl compounds with unsaturated carboxylic acids may include acrylic esters such as methyl acrylate ethyl acrylate, n-propyl acrylate, isopropyl acrylate, n-butyl acrylate and tert-butyl acrylate; methacrylic esters such as methyl methacrylate, ethyl methacrylate, n-propyl methacrylate, isopropyl methacrylate, n-butyl methacrylate and tert-butyl methacrylate; itaconic esters such as methyl itaconate, ethyl itaconate, n-propyl itaconate, isopropyl itaconate, n-butyl itaconate and tert-butyl itaconate; crotonic esters such as methyl crotonate, ethyl crotonate, n-propyl crotonate, iso-propyl crotonate, n-butyl crotonate and tert-butyl crotonate; etc.

Examples of the esters of aliphatic polyhydroxyl compound and unsaturated carboxylic acid may include acrylic esters such as ethylene glycol diacrylate, triethylene glycol triacrylate, 1,3-butanediol diacrylate, tetramethylene glycol diacrylate, propylene glycol diacrylate, trimethylolpropane triacrylate, trimethylolethane triacrylate, tetraethylene glycol diacrylate, pentaerithritol diacrylate, pentaerithritol triacrylate, pentaerithritol tetraacrylate, dipentaerithritol diacrylate, dipentaerithritol triacrylate, dipentaerithritol tetraacrylate dipentaerithritol pentaacrylate, dipentaerithritol hexaacrylate, tripentaerithritol octaacrylate, sorbitol triacrylate, sorbitol tetraacrylate, sorbitol pentaacrylate, sorbitol hexaacrylate and polyester acrylate oligomer; methacrylic esters such as tetramethylene glycol dimethacrylate, triethylene glycol dimethacrylate, trimethylolpropane trimethacrylate,

trimethylolethane trimethacrylate, pentaerithritol dimethacrylate, pentaerithritol trimethacrylate, dipentaerithritol dimethacrylate, dipentaerithritol tetramethacrylate, tripentaerithritol octamethacrylate, ethylene glycol dimethacrylate, 1,3-butanediol dimethacrylate, tetramethylene glycol dimethacrylate and sorbitol tetramethacrylate; itaconic esters such as ethylene glycol diitaconate, propylene glycol diitaconate, 1,3-butanediol diitaconate, 1,4-butanediol diitaconate, tetramethylene glycol diitaconate, pentaerithritol diitaconate, dipentaerithritol triitaconate, dipentaerithritol pentaitaconate, dipentaerithritol hexaitaconate and sorbitol tetraitaconate; crotonic esters such as ethylene glycol dicrotonate, propylene glycol dicrotonate, tetramethylene glycol dicrotonate, pentaerithritol dicrotonate and sorbitol tetracrotonate; isocrotonic esters such as ethylene glycol diisocrotonate, pentaerithritol diisocrotonate and sorbitol tetraisocrotonate; maleic esters such as ethylene glycol dimaleate, triethylene glycol dimaleate, pentaerithritol dimaleate and sorbitol tetramaleate; and a mixture of some of these esters.

Examples of the oligoesters may include oligoester acrylate and oligoester methacrylate (hereinafter referred to merely as oligoester(metha)acrylate, thereby representing both or either one of these).

The oligoester(metha)acrylate is a reaction product obtained by esterification reaction of acrylic or methacrylic acid and a polycarboxylic acid with a polyol, and is assumed to have a chemical structure of the formula:

$$(CH_2 = \overset{\displaystyle R}{\overset{|}{C}} - \overset{\displaystyle O}{\overset{\|}{C}} - O \rightarrow_{p} Q$$

(wherein, R represents a hydrogen atom or a methyl group, Q represents a residue having at least one ester bond and being formed by condensation of the polyol and the polycarboxylic acid, and p is an integer of 1 to 6).

Example of the polyol giving the residue represented by Q may include polyols such as ethylene glycol, 1,2-propylene glycol, 1,4-butanediol, 1,6-hexanediol, trimethylolpropane, trimethylolethane, 1,2,6-hexanetriol, glycerol, pentaerithritol and sorbitol; polyether type polyols such as diethylene glycol, triethylene glycol, tetraethylene glycol, decaethylene glycol, polyethylene glycol, dipropylene glycol, tripropylene glycol, tetrapropylene glycol and polypropylene glycol, etc.

Examples of the polycarboxylic acid giving the residue represented by Q may include aromatic polycarboxylic acids such as phthalic acid, isophthalic acid, terephthalic acid, tetrachlorophthalic acid, tetrabromophthalic acid, trimellitic acid, pyromellitic acid, benzophenone dicarboxylic acid and resorcinol diacetic acid; unsaturated aliphatic polycarboxylic acids such as maleic acid, fumaric acid, Himic Acid (trademark, produced by Hitachi Chemical Co., Ltd.) and itaconic acid; saturated aliphatic polycarboxylic acid such as malonic acid succinic acid, glutaric acid, adipic acid, pimelic acid, sebacic acid, dodecanoic acid and tetrahydrophthalic acid, etc.

As the acid anhydride which may be used in the invention, there may be mentioned may include phthalic anhydride, tetrahydrophthalic anhydride, methyltetrahydrophthalic anhydride, hexahydrophthalic anhydride, methylhexahydrophthalic anhydride, maleic anhydride, trimellitic anhydride and hexachloroendomethylenetetrahydrophthalic anhydride. These should be mixed in an amount of generally 0.2 to 1.5, preferably 0.5 to 1.2 equivalent, based on the epoxy resin.

BAD ORIGINAL

The aluminum compound to be used in this invention may be either inorganic aluminum compounds or organic aluminum compounds, but is preferably compounds having an organic group selected from the group consisting of an alkoxy group, a phenoxy group, an acyloxy group, a β-diketonato group, an o-carbonylphenolato group, etc.

Of the above organic groups, examples of the alkoxy group may include a methoxy group, an ethoxy group, an isopropoxy group, a butoxy group, a pentoxy group, etc;, examples of the phenoxy group may include a phenoxy group, an o-methylphenoxy group, an o-methoxyphenoxy group, a p-nitrophenoxy group, a 2,6-dimethylphenoxy group, etc; examples of the acyloxy group may include an acetato group, a propionato group, an isopropionato group, a butylato group, a stearato group, an ethylacetoacetato group, a propylacetoacetato group, an isopropylacetoacetato group, an n-butylacetoacetato group, a sec-butylacetoacetato group, a diethylmalonato group, a dipivalaloylmethanato group, etc.; examples of the β-diketonato group may include an acetylacetonato group, a trifluoroacetylacetonato group, a hexafluoroacetylacetonato group,

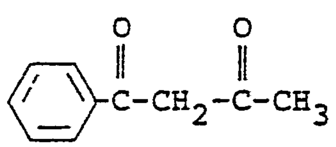 , 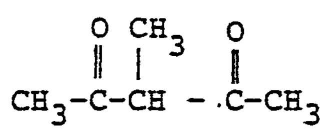 ,

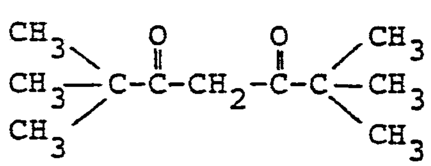

, etc.; and examples of the o-carbonylphenolato group may include a salicylaldehydato group, etc.

More specifically, examples of the aluminum compounds mentioned above may include trismethoxyaluminum trisethoxyaluminum, trisisopropoxyaluminum, trisphenoxyaluminum, trisparamethylphenoxyaluminum,

0114258

isopropoxydiethoxyaluminum, trisbuthoxyaluminum, trisacetoxyaluminum, trisstearatoaluminum, trisbutylatoaluminum, trispropionatoaluminum, trisisopropionatoaluminum, trisacetylacetonatoaluminum, trisfluoroacetylacetonatoaluminum, trishexafluoroacetylacetonatoaluminum, trisethylacetoacetatoaluminum, tris(n-propylacetoacetato)aluminum, tris(isopropylacetoacetato)aluminum, tris(n-butylacetoacetato)aluminum, trissalycilaldehydatoaluminum, trisdiethylmalonatoaluminum, trispropylacetoacetatoaluminum, trisbutylacetoacetatoaluminum, trisdipivaloylmethanatoaluminum, diacetylacetonatodipivaloylmethanatoaluminum,

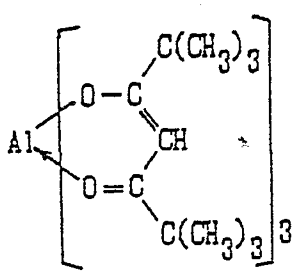 , 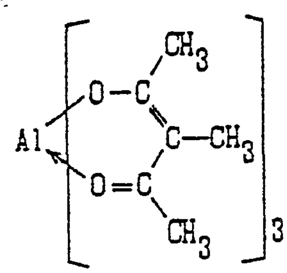 , 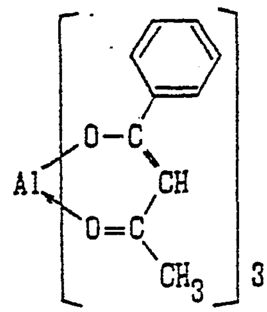 ,

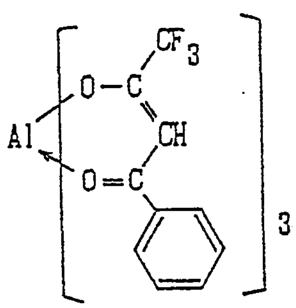 , 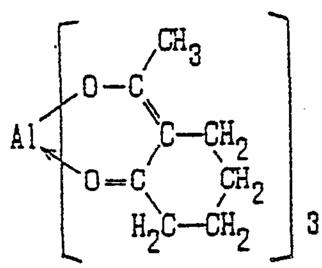 , 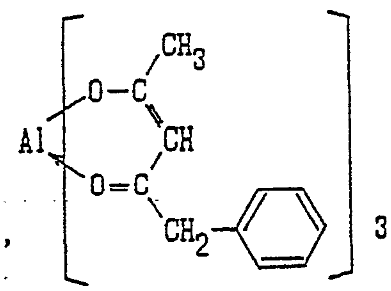 ,

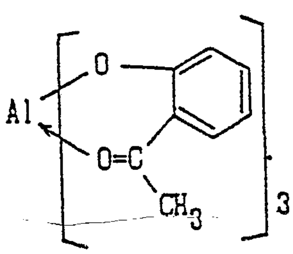 , 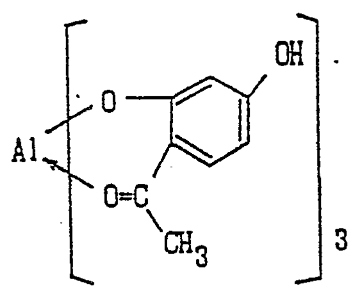 ,

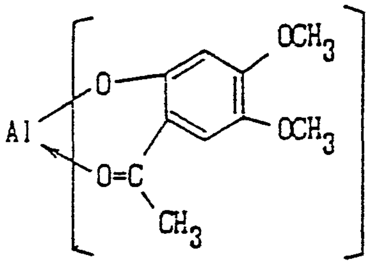 3 , 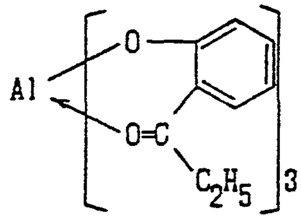

, etc.

These aluminum compounds may be used alone or in combination. The compound(s) should be mixed preferably in an amount of 0.001 to 10% by weight, more preferably in an amount ranging from 0.05 to 5% by weight, based on the epoxy resin. If the amount is less than 0.001% by weight, sufficient curability of the product will not be obtained; if it exceeds 10% by weight on the other hand, a high cost of production and a poor electrical property of the product will be caused thereby.

The silicon compound i) having a peroxysilyl group to be used in this invention is represented by the following formula:

$$(R^1)_n - Si \leftarrow\!\!(- O - O - R^2)_{4-n}$$

(wherein $R^1$ represents a hydrogen atom, a halogen atom, an alkyl group having 1 to 5 carbon atoms, an alkoxy group having 1 to 5 carbon atoms or an aryl group; $R^2$ represents a hydrogen atom, an alkyl group having 1 to 10 carbon atoms or an aryl group; and n is an integer of 0 to 3).

In the above formula, examples of the alkyl group having 1 to 5 carbon atoms may include a methyl group, an ethyl group, a n-propyl group, an isopropyl group, a n-butyl group, a t-butyl group, a sec-butyl group, a n-pentyl group, etc.; examples of the alkoxy group having 1 to 5 carbon atoms may include a methoxy group, an ethoxy

group, a n-propoxy group, an isopropoxy group, a n-butoxy group, a t-butoxy group, a sec-butoxy group, a n-pentoxy group, etc.; examples of the aryl group may include a phenyl group, a naphthyl group, an anthranil group, a benzyl group, an α,α-dimethylbenzyl group, a 1,2,3,4-tetrahydro-1-naphthyl group etc. The alkyl group having 1 to 5 carbon atoms and the aryl group may have a substituent or substituents such as a halogen atom, a nitro group, a cyano group or a methoxy group.

More specifically, examples of the silicon compound having the peroxysilyl group may include compounds of the following formulae:

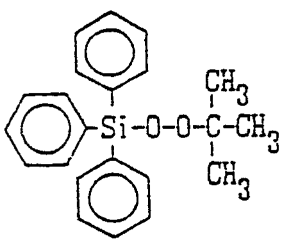 , 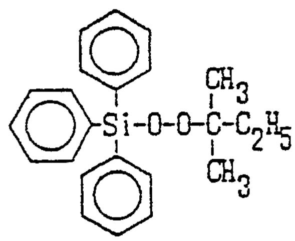 , 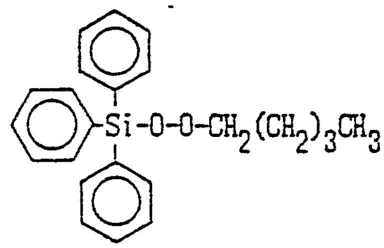 ,

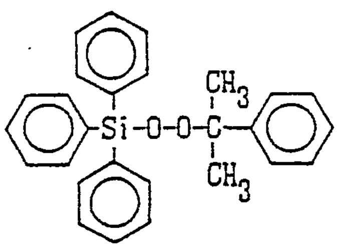 , 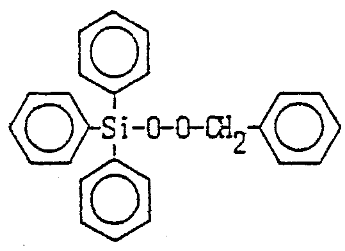 , 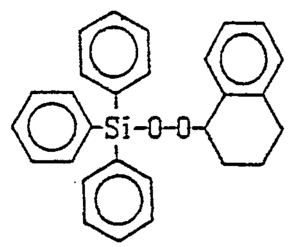 ,

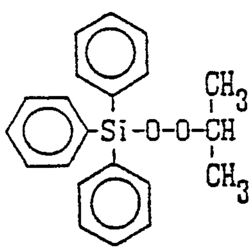 , 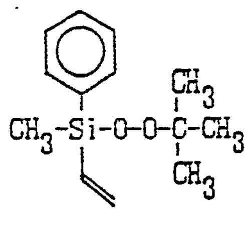 , 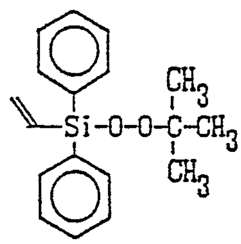 ,

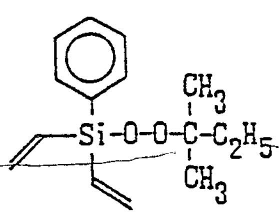 , 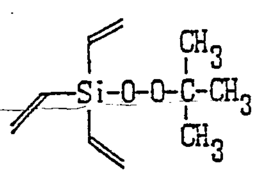 , 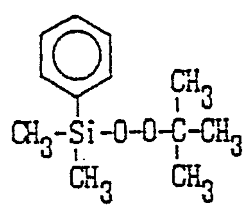 ,

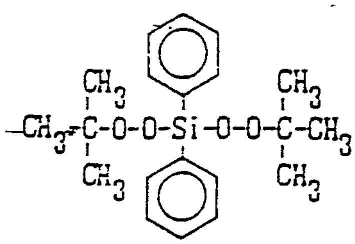,
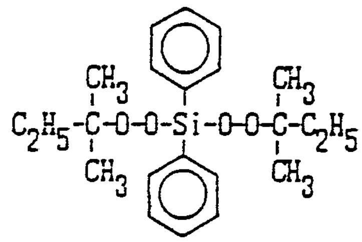,
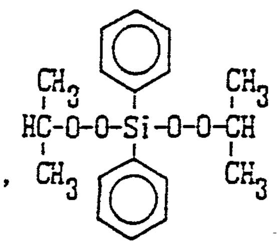,

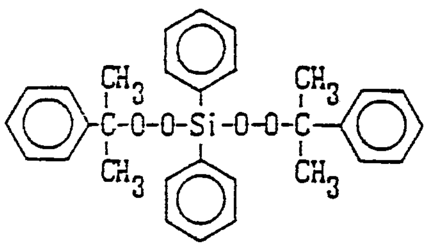,
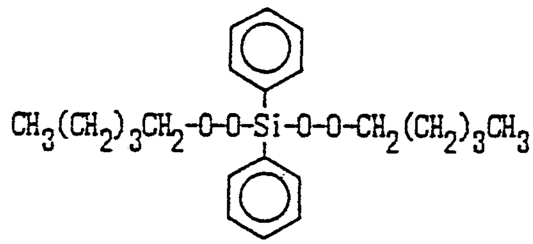,

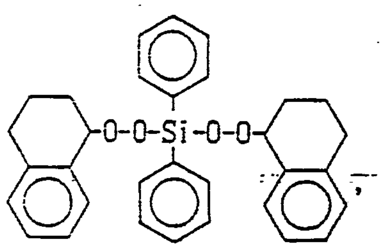,
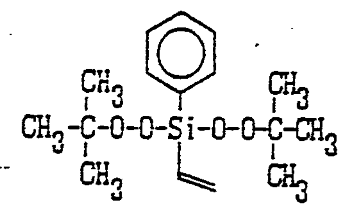,
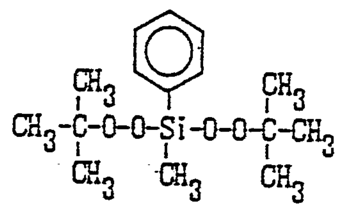

etc.

The silicon compound of the above should be mixed preferably in an amount ranging from 0.01 to 20% by weight, more preferably in an amount of from 1 to 10% by weight based on the epoxy resin. If the amount is less than 0.01% by weight, sufficient curability will not be obtained; if it exceeds 20% by weight on the other hand, the cost of production becomes high and a product formed by decomposition of the catalyst components may cause some problems.

The silicon compound ii) having an α-ketosilyl group is a compound represented by the following formula:

$$(R)_n - Si \left( - \overset{O}{\overset{\|}{C}} - R \right)_{4-n}$$

(wherein $\underline{n}$ represents an integer of 0, 1, 2 or 3; and R represents a hydrocarbon group such as an alkyl group or

an aromatic group, which groups, however, may have a substituent or substituents such as a halogen, $NO_2$, CN, or $-OCH_3$). Examples of this compound may include the following compounds:

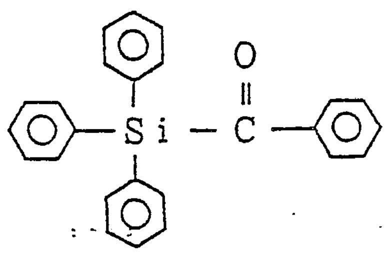 , 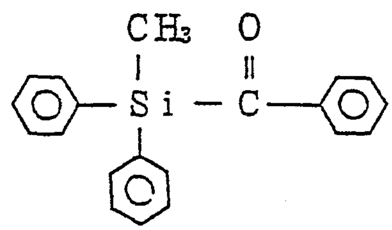 ,

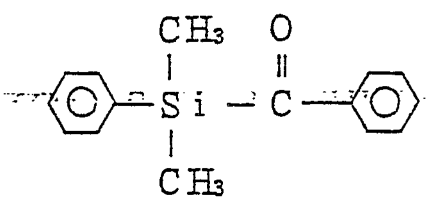 , 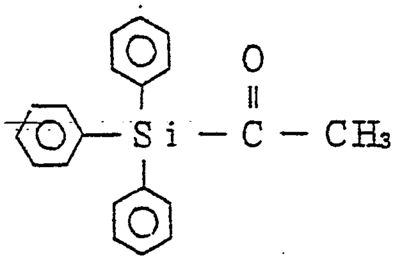 ,

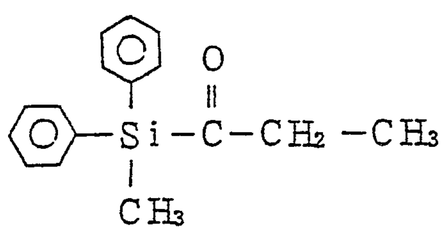 , 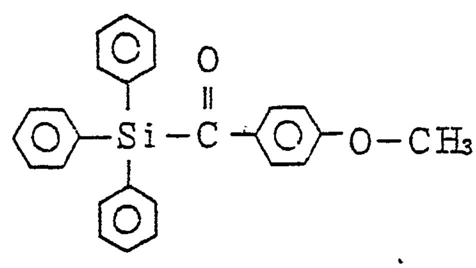 ,

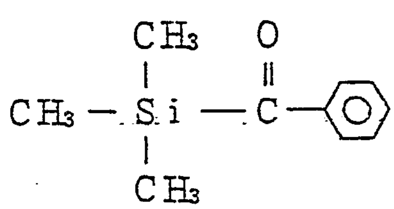 , 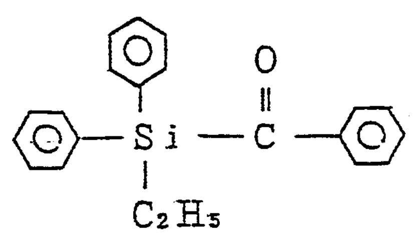 ,

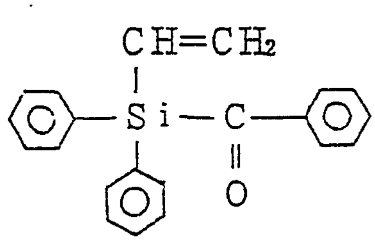

, etc.

BAD ORIGINAL

The above compound should be mixed generally in an amount ranging from 0.1 to 10% by weight based on the epoxy resin. If the amount is less than 0.1% by weight, sufficient curability of the product will not be obtained. It is not preferred, though practicable, that the amount exceeds 10% by weight, because the cost of production becomes high and a product formed by decomposition of catalyst components may cause problems.

The silicon compound iii) having an o-nitrobenzyloxy group to be used in this invention is a compound represented by the following formula:

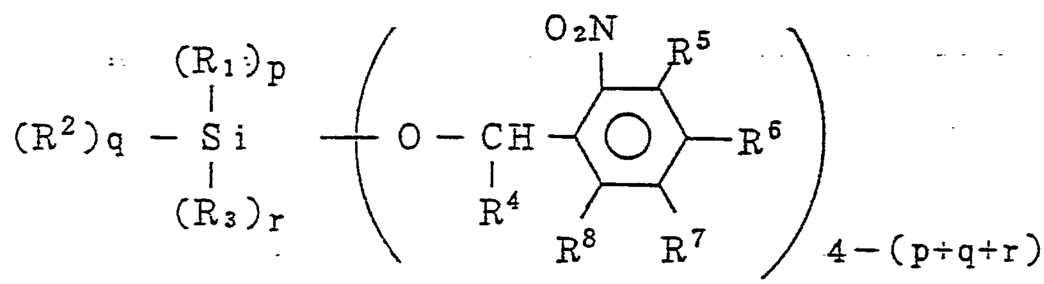

(wherein p, q and r are integers satisfying the conditions of $0 \leq p, q, r \leq 3$ and $1 \leq p + q + r \leq 3$).

In the above formula, $R^1$, $R^2$ and $R^3$ may be same or different and each represent a hydrogen atom; a halogen atom; a vinyl group; an allyl group; a substituted or unsubstituted alkyl group having 1 to 10 carbon atoms such as a methyl group, an ethyl group, a propyl group, a butyl group, a t-butyl group, a chloromethyl group, a chloroethyl group, a fluoromethyl group and cyanomethyl group; an alkoxy group having 1 to 10 carbon atoms such as a methoxy group and an ethoxy group; a substituted or unsubstituted aryl group such as a phenyl group, a p-methoxy phenyl group, a p-chlorophenyl group and a p-trifluoromethylphenyl group; an aryloxy group such as a phenoxy group; a siloxy group; etc.

$R^4$ represents a hydrogen atom; a substituted or

BAD ORIGINAL

unsubstituted alkyl group having 1 to 10 carbon atoms such as a methyl group, an ethyl group, a propyl group, a cyanomethyl group, a chloromethyl group and a fluoroethyl group; a phenyl group; a substituted phenyl group such as a p-methoxyphenyl group, a p-chlorophenyl group and an o-nitrophenyl group.

$R^5$ to $R^8$ may be same or different and each represent a hydrogen atom; a nitro group; a cyano group; a hydroxyl group; a mercapto group; a halogen atom; an acetyl group; an allyl group; a substituted or unsubstituted alkyl group having 1 to 5 carbon atoms such as a methyl group, an ethyl group, a pentyl group and a chloromethyl group; an alkoxy group having 1 to 5 carbon atoms such as a methoxy group and an ethoxy group; a substituted or unsubstituted aryl group such as a phenyl group and a p-methoxyphenyl group; an aryloxy group such as a phenoxy group; etc.

Alternatively, the organic silicon compound iii) may be a compound having as a terminal group an o-nitrobenzyloxysilyl group and as a principal chain a group represented by the formula:

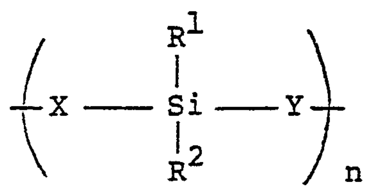

(wherein _n_ is an integer of 0 or 1 to 100, preferably 0 or 1 to 10; $R^1$ and $R^2$ are as defined in the foregoing; X and Y may be same or different and each represent an oxygen atom, an alkylene group, an aryl group, or the like).

Examples of the organic silicon compound iii) having the substituted or unsubstituted o-nitrobenzyloxy group bonded directly to a silicon atom may include the following compounds;

BAD ORIGINAL

(1) trimethyl(o-nitrobenzyloxy)silane,
(2) dimethylphenyl(o-nitrobenzyloxy)silane,
(3) diphenylmethyl(o-nitrobenzyloxy)silane,
(4) triphenyl(o-nitrobenzyloxy)silane,
(5) vinylmethylphenyl(o-nitrobenzyloxy)silane,
(6) t-butylmethylphenyl(o-nitrobenzyloxy)silane,
(7) triethyl(o-nitrobenzyloxy)silane,
(8) tri(2-chloroethyl)-o-nitrobenzyloxysilane,
(9) tri(p-trifluoromethylphenyl)-o-nitrobenzyloxysilane,
(10) trimethyl[α-(o-nitrophenyl)-o-nitrobenzyloxy]silane,
(11) dimethylphenyl[α-(o-nitrophenyl)-o-nitrobenzyloxy]- silane,
(12) methylphenyldi[α-o-nitrophenyl)-o-nitrobenzyloxy]-silane,
(13) triphenyl(α-ethyl-o-nitrobenzyloxy)silane,
(14) trimethyl(3-methyl-2-nitrobenzyloxy)silane,
(15) dimethylphenyl(3,4,5-trimethoxy-2-nitrobenzyloxy)-silane,
(16) triphenyl(4,5,6-trimethoxy-2-nitrobenzyloxy)silane,
(17) diphenylmethyl(5-methyl-4-methoxy-2-nitrobenzyloxy)-silane,
(18) triphenyl(4,5-dimethyl-2-nitrobenzyloxy)silane,
(19) vinylmethylphenyl(4,5-dichloro-2-nitrobenzyloxy)-silane,
(20) triphenyl(2,6-dinitrobenzyloxy)silane,
(21) diphenylmethyl(2,4-dinitrobenzyloxy)silane,
(22) triphenyl(3-methoxy-2-nitrobenzyloxy)silane,
(23) vinylmethylphenyl(3,4-dimethoxy-2-nitrobenzyloxy)-silane,
(24) dimethyldi((o-nitrobenzyloxy)silane,
(25) methylphenyldi(o-nitrobenzyloxy)silane,
(26) vinylphenyldi(o-nitrobenzyloxy)silane,
(27) t-butyldi(o-nitrobenzyloxy)silane,
(28) diethyldi(o-nitrobenzyloxy)silane,
(29) 2-chloroethylphenyldi(o-nitrobenzyloxy)silane,
(30) diphenyldi(o-nitrobenzyloxy)silane,
(31) diphenyldi(3-methoxy-2-nitrobenzyloxy)silane,

BAD ORIGINAL

(32) diphenyldi(3,4-dimethoxy-2-nitrobenzyloxy)silane,
(33) diphenyldi(2,6-dinitrobenzyloxy)silane,
(34) diphenyldi(2,4-dinitrobenzyloxy)silane,
(35) methyltri(o-nitrobenzyloxy)silane,
(36) phenyltri(o-nitrobenzyloxy)silane,
(37) p-bis(o-nitrobenzyloxydimethylsilyl)benzene,
(38) 1,1,3,3-tetraphenyl-1,3-di(o-nitrobenzyloxy)siloxane,
(39) 1,1,3,3,5,5-hexaphenyl-1,5-di(o-nitrobenzyloxy)-siloxane, and
(40) a silicon compound formed by reaction of SiCl-containing silicone resin and o-nitrobenzylalcohol.

The organic silicon compounds as exemplified above may be used alone or in combination of two or more kinds.

The compound(s) should be mixed generally in an amount of from 0.001 to 10% by weight, preferably in an amount ranging from 0.1 to 5% by weight, based on the epoxy resin.

As the photosensitizer used in this invention, there may be employed any of those which are capable of photosensitizing the foregoing compounds, and which are selected depending on the kinds of the epoxy resins, light source, etc.

Examples of the above photosensitizers may include aromatic hydrocarbons, benzophenone and derivatives thereof, esters of o-benzoylbenzoic acids, acetophenone and derivatives thereof, benzoin and benzoin ethers and derivatives thereof, xanthone and derivatives thereof, thioxanthone and derivatives thereof, disulfide compounds, quinone compounds, halogenated hydrocarbons, amines, etc.

Examples of the aromatic hydrocarbon may include benzene, benzene-$d_6$, toluene, p-xylene, fluorobenzene, chlorobenzene, bromobenzene, iodobenzene, naphthalene,

BAD ORIGINAL

1-methylnaphthalene, 2-methylnaphthalene, 1-fluoronaphthalene, 1-chloronaphthalene, 2-chloronaphthalene, 1-bromonaphthalene, 2-bromonaphthalene, 1-iodonaphthalene, 2-iodonaphthalene, 1-naphthol, 2-naphthol, biphenyl, fluorene, p-terphenyl, acenaphthene, p-quaterphenyl, triphenylene, phenanthrene, azulene, fluoranthene, chrycene, pyrene, 1,2-benzpyrene, anthracene, 1,2-benzanthracene, 9,10-dichloroanthracene, 9,10-dibromoanthracene, 9,10-diphenylanthracene, perylene, tetracene, pentacene, etc.

Examples of the benzophenone and the derivatives thereof may include benzophenone, 2,4-dimethylbenzophenone, 2,4-dichlorobenzophenone, 4,4'-bis(dimethylamino)benzophenone, etc.

Examples of the esters o-benzoylbenzoic acids may include methyl o-benzoylbenzoate, ethyl o-benzoylbenzoate, phenyl o-benzoylbenzoate,

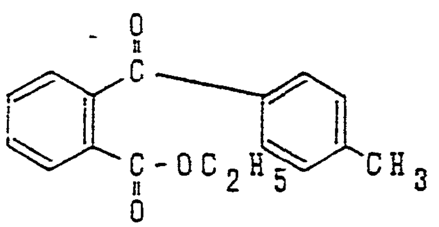
,
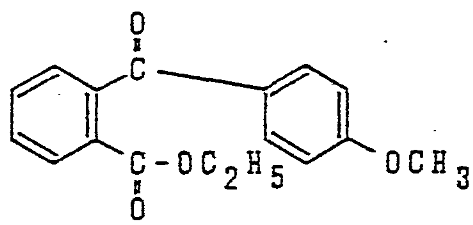
,

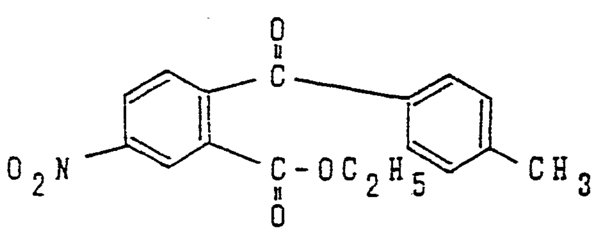

, etc.

Examples of the acetophenone and the derivatives thereof may include acetophenone, 4-methylacetophenone, 3-methylacetophenone, 3-methoxyacetophenone, etc.

BAD ORIGINAL

Examples of the benzoin, the benzoin ethers and the derivatives of these may include benzoin, benzoin methyl ether, benzoin ethyl ether, benzoin isopropyl ether, benzoin n-butyl ether, benzoin triphenylsilyl ether,

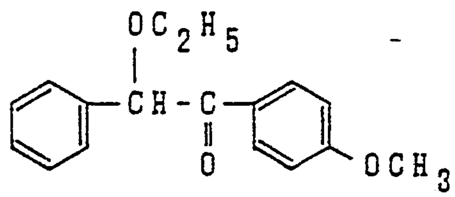

, etc.

Examples of the xanthone and the derivatives thereof may include xanthone, 2,4-dimethylxanthone, 2,4-dichloroxanthone, etc.

Examples of the thioxanthone and the derivatives thereof may include thioxanthone, 2,4-dimethylthioxanthone, 2,4-dichlorothioxane, etc.

Examples of the disulfide compounds may include;

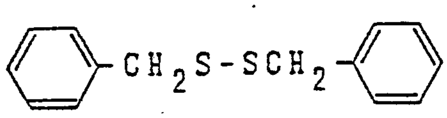

,

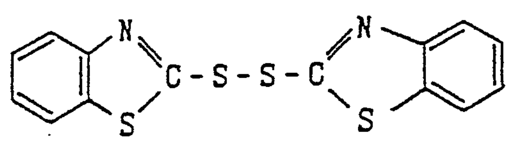

,

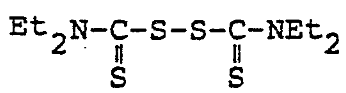

, etc.

Examples of the quinone seriese compounds may include benzoquinone, naphthoquinone, anthraquinone, 5,12-naphthacene dione, 2,7-pyrene dione, etc.

Examples of the halogenated hydrocarbons may include carbon tetrachloride, hexachloroethane, carbon tetrabromide,

BAD ORIGINAL

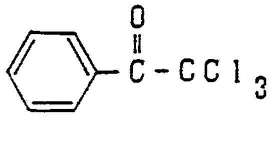 , 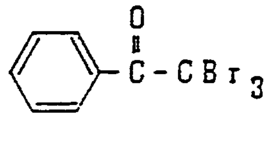 , 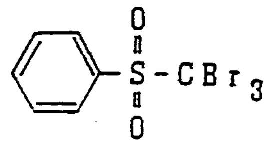 ,

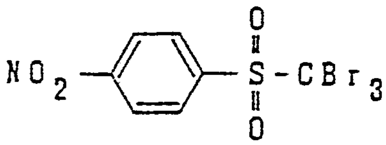 , 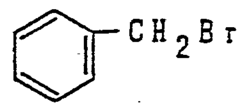 ,

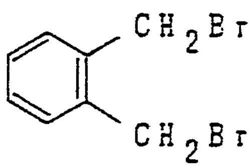 , 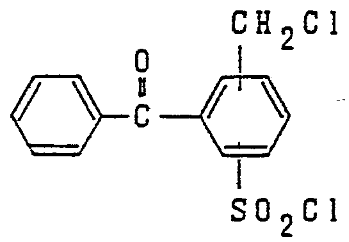 ,

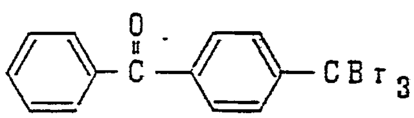 , 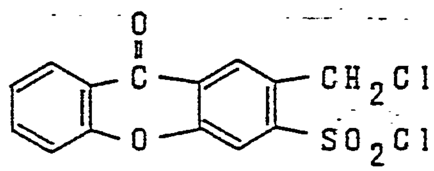 ,

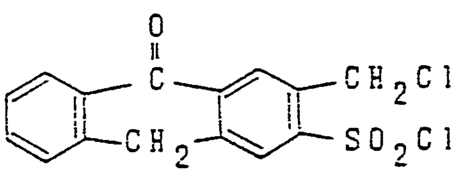 , 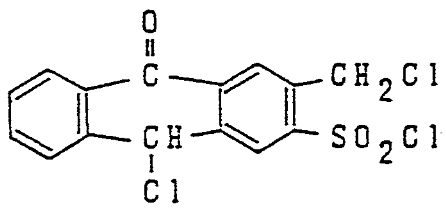 ,

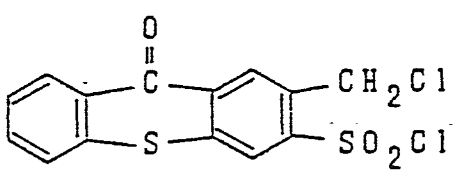 , 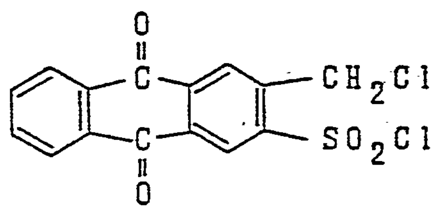 ,

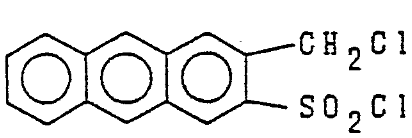 , 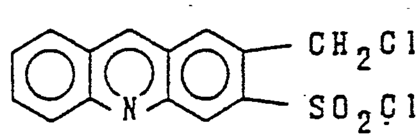 ,

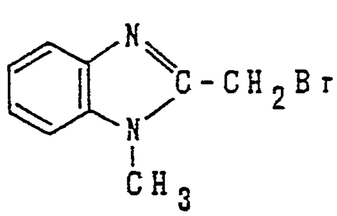 , 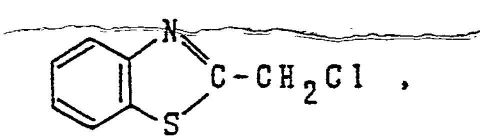 ,

BAD ORIGINAL

0114258

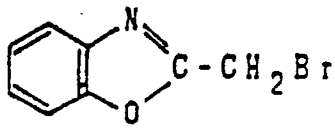 , 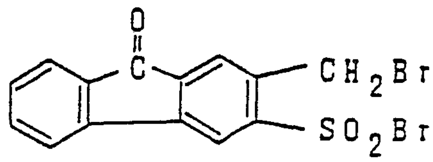 ,

,etc.

Examples of the amines may include diphenylamine, carbazole, triphenylamine,

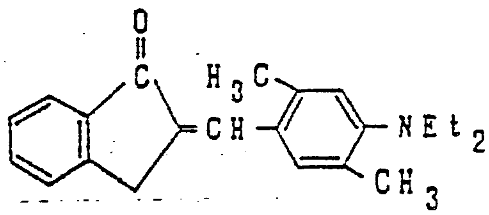 , 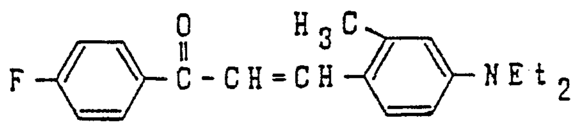 ,

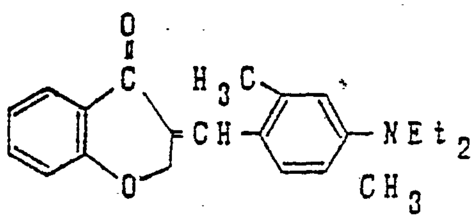 , 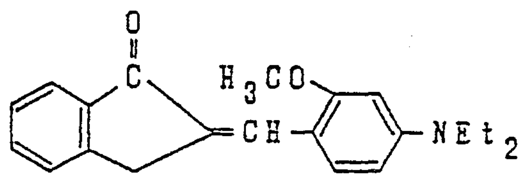 ,

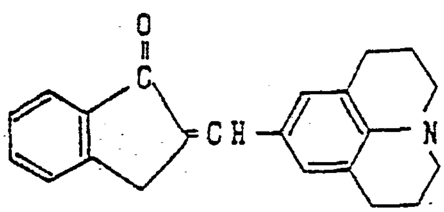

, etc.

Examples of the other photosensitizers may include propiophenone, anthrone, benzaldehyde, butylophenone, 2-naphthylphenylketone, 2-naphthaldehyde, 2-acetonaphthone, 1-naphtylphenylketone, 1-acetonaphthone, 1-naphthoaldehyde, fluorenone, 1-phenyl-1,2-propane dione, benzoethrile, acetone, biacetyl, acridine orange, acridine, Rhodamine-B, eosine, fluorescein,

BAD ORIGINAL

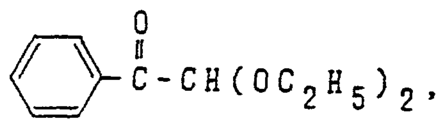, 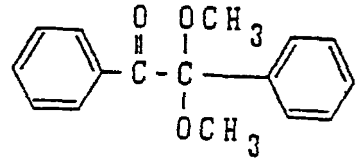 ,

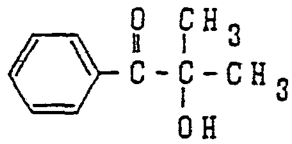 , 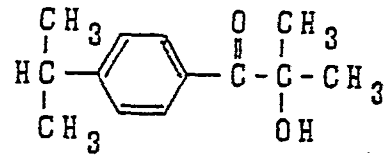 ,

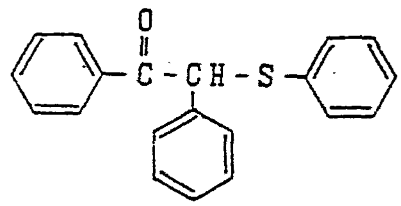 , 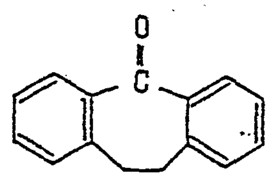 ,

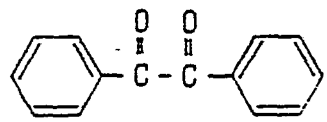

, etc.

The photosensitizers exemplified in the above may be used alone or in combination, and should be mixed preferably in an amount of from 0.001 to 10% by weight, more preferably 0.01 to 5% by weight, based on the epoxy resin.

The epoxy resin composition used in this invention may further contain an active proton-containing compound to enhance the catalyst activity. As the active proton-containing compoumd, there may be mentioned water, alcohol, thiol, etc., which may be added alone or in combination. Preferable examples thereof include alcohols having 1 to 5 carbon atoms such as methyl alcohol, ethyl alcohol and propyl alcohol, and thiols having 1 to 5 carbon atoms such as methane thiol, ethane thiol and propane thiol. These active proton-containing compounds should be added generally in an amount of from 0.01 to 10 % by weight based on the epoxy resin. These

BAD ORIGINAL

compounds do not inversely affect the performances of the cured products since they are incorporated into the catalyst components through the photoreaction.

Besides the above-mentioned components, it is possible to mix, if necessary, a coloring agent, an inorganic filler or other additives into the photocurable epoxy resin composition used in this invention.

A method of manufacturing the resin encapsulation type photo-semiconductor device according to this invention is carried out by encapsulating a photo-semiconductor device with use of the foregoing photocurable epoxy resin composition by a conventional encapsulation method such as potting, casting, dipping or dropping, and then curing it by irradiation with the aforementioned energy rays such as light, in particular, with UV. The wavelength of the light with which the composition is irradiated for the potocuring is varied depending on the kind of resin composition and the encapsulation method, but, in general, it ranges from 180 to 700 nm, preferably from 250 to 500nm.

Light irradiation time is also varied depending on the kind of the resin composition, the encapsulation method and the light sourse. In general, it ranges from 10 seconds to 180 minutes, preferably 30 seconds to 30 minutes, when the resin composition comprises the aforementioned silicon compound i) having a peroxysilyl group; one minute to 5 hours when the resin composition comprises the silicon compound ii) having an α-ketosilyl group; and 10 seconds to 30 minutes when the resin composition comprises the silicon compound iii) having an o-nitrobenzyloxy group.

As the light source for the light irradiation, it is possible to use a high pressure mercury-vapor lamp, a

BAD ORIGINAL

carbon arc lamp, a xenon lamp, an argon glow discharge lamp, a metal halide lamp, etc.

This invention will be described in greater detail by giving the following Examples:

Example 1

(Preparation of resin composition)

| | |
|---|---|
| ERL-4221* (trademark, produced by Union Carbide Corp., an alicyclic epoxy resin, epoxy equivalent: 145) | 400 g |
| Epikote 1004 (trademark, produced by Shell International Chemicals Corp., bisphenol A type epoxy resin, epoxy equivalent: 900 to 1000, molecular weight: about 1400) | 100 g |
| Tris(n-butylacetoacetonato)aluminum | 1 g |
| Diphenyldi(tert-butylperoxy)silane | 10 g |

* 3,4-epoxycyclohexylmethyl-3'-4'-epoxycyclohexane carboxylete

An epoxy resin composition of the above combination was stirred under heating at 60°C for 10 minutes to obtain a homogeneous resin composition for encapsulation.

(Encapsulation of light-emitting element)

Dipped into the resin composition thus prepared was a light-emitting, which was then pulled out and subjected to irradiation with light for 2 minutes. Employed as the light source were two sets of high pressure mercury-vapor lamps of 2 KW each, and irradiation was carried out at a position 10 cm distant from the light source. Performances of aresin encapsulation type light-emitting device thus manufactured were tested to obtain the results shown in Table 1.

BAD ORIGINAL

Table 1

| | |
|---|---|
| Appearance : | colorless and transparent |
| Water resistance : | no deterioration of photo-output $P_o$ at 90°C, 90% RH, after 2000 Hr. |
| Heat resistance : | no deterioration of photo-output $P_o$ at 120°C, after 1000 Hr. |
| Soldering resistance : | no crack appeared when immersed for 15 seconds into a soldering bath of 300°C |
| Continuous energizing test: | deterioration of $P_o$ under conditions of $I_F$ = 40 mA, 25°C, after 110 Hr: -30% |

Example 2

(Preparation of resin composition)

| | |
|---|---|
| Epikote 828 (trademark, produced by Shell International Chemical Corp., a bisphenol-A type epoxy resin, epoxy equivalent: 190 to 210, molecular weight: 380) | 250 g |
| ERL-4221 | 250 g |
| Trissalicylaldehydatoaluminum | 0.5 g |
| Triphenyl(tert-butylperoxy)silane | 15 g |

An epoxy resin composition of the above combination was stirred under heating at 50°C for 10 minutes to obtain a homogeneous resin composition for encapsulation.

(Encapsulation of light-emitting element)

The resin composition thus prepared was poured into a transparent container, into which a light-emitting element was inserted until it was buried at a

BAD ORIGINAL

predetermined position. Thereafter, irradiation with light was made for 3 minutes. Employed as the light source were two sets of metal halide lamps of 2 KW each, and the irradiation was made at a position 10 cm distant from the light source. Performances of a resin encapsulation type light-emitting device thus manufactured were tested to obtain the results shown in Table 2.

Table 2

| | |
|---|---|
| Appearance | : pale yellow, transparent |
| Water resistance | : no deterioration of photo-output $P_o$ at 90°C, 90% RH, after 2000 Hr. |
| Heat resistance | : no deterioration of photo-output $P_o$ at 120°C, after 1000 Hr. |
| Soldoring resistance | : no crack appeared when immersed for 15 seconds into a soldering bath of 300°C. |
| Continuous energizing test: | deterioration of $P_o$ under conditions of $I_F$ = 40 mA, 25°C, after 110 Hr: -25% |

Example 3

(Preparation of resin composition)

| | |
|---|---|
| ERL-4221 | 200 g |
| 4-Methylhexahydrophthalic anhydride | 160 g |
| Trisethylacetonatoaluminum | 1 g |
| Triphenyl(α,α-benzylperoxy)silane | 6 g |

An epoxy resin composition of the above combination was stirred under heating at 50°C for 10 minutes to obtain a

BAD ORIGINAL

homogeneous resin compsotion for encapsulation.

(Encapsulation of light-emitting element)

The resin composition thus prepared was poured into a transparent container, into which a light-emitting element was inserted and irradiation with light was made for 2 minutes. Employed as the light source were two sets of high pressure mercury-vapor lamps of 2 KW each, and the irradiation was made at a position 10 cm distant from the light source. Performances of a resin encapsulation type light-emitting device thus manufactured were tested to obtain the results shown in Table 3.

Table 3

| | | |
|---|---|---|
| Appearance | : | colorless and transparent |
| Water resistance | : | no deterioration of photo-output $P_o$ at 90°C, 90% RH, after 2000 Hr. |
| Heat resistance | : | no deterioration of photo-output $P_o$ at 120°C, after 1000 Hr. |
| Soldering resistance | : | no cracks appeared when immersed for 15 seconds into a soldering bath of 300°C. |
| Continuous energizing test | : | deterioration of $P_o$ under conditions of $I_F$ = 40 mA, 25°C, after 110 Hr: -35% |

BAD ORIGINAL

Example 4

(Preparation of resin composition)

| | |
|---|---|
| ERL-4221 | 210 g |
| Epikote 1004 | 90 g |
| Hexahydrophthalic anhydride | 100 g |
| Tris(n-butylacetoacetonato)aluminum | 1 g |
| Diphenyldi(tert-butylperoxy)silane | 10 g |

An epoxy resin composition of the above combination was stirred under heating at 60°C for 10 minutes to obtain a homogeneous resin composition for encapsulation.

(Encapsulation of light-emitting element)

Dipped into the resin composition thus prepared was a light-emitting element, which was then pulled out and subjected to irradiation with light for 2 minutes. Employed as the light source were two sets of metal halide lamps of 2 KW each, and irradiation was made at a position 10 cm distant from the light source. Performances of a resin encapsulation type light-emitting device were tested to obtain the results shown in Table 4.

Table 4

| | | |
|---|---|---|
| Appearance | : | colorless, transparent |
| Water resistance | : | no deterioration of photo-output $P_o$ at 90°C, 90% RH, after 2000 Hr. |
| Heat resistance | : | no deterioration of photo-output $P_o$ at 120°C, after 1000 Hr. |
| Soldering resistance | : | no cracks appeared when immersed for 15 seconds into a soldering bath of 300°C. |
| Continuous energizing test: | | deterioration of $P_o$ under conditions of $I_F$ = 40 mA, 25°C, after 110 Hr. |

BAD ORIGINAL

Examples 5 to 16

(Preparation of resin composition)

Twelve kinds of photocurable epoxy resin type compositions each having the composition as shown in Table 5 were prepared.

As shown in the Table, employed as epoxy resin were ERL-4221, Chissonox 206* (trademark, produced by Chisso Corporation, an alicyclic epoxy resin of the formula (I) infra), Chissonox 234** (trademark, produced by Chisso Corporation, an alicyclic epoxy resin of the formula (II) infra, epoxy equivalent: about 140), Epikote 828, Epikote 1001 (tradename, produced by ditto, epoxy equivalent: 450 to 525, molecular weight: 900) and Epikote 1004.

* 4-vinylcyclohexene dioxide

** 2-(3,4-epoxycylclohexyl-5,5-spiro-3,4-epoxy)-cyclohexane-meta-dioxane

As phenol series compounds, employed were (1) bisphenol A and (2) phenol.

As ethylenic compounds, employed were (3) ethylene glycol diacrylate and (4) 1,3-dibutanediol dimethacrylate.

As acid anhydrides, employed were (5) hexahydrophthalic anhydride, (6) methylhexahydrophthalic anhydride and (7) methyltetrahydrophthalic anhydride.

As aluminum compounds, employed were;
(i) tris(isopropylacetoacetato)aluminum,
(ii) tris(n-butylacetylacetato)aluminum,
(iii) trisacetylacetonatoaluminum,
(iv) tris(ethylacetoacetato)aluminum, and
(v) trissalicylaldehydatoaluminum.

As silicon compounds, employed were;

(a) triphenyl(tert-butylperoxy)silane,

(b) triphenyl(α,α'-dimethylbenzylperoxy)silane,

(c) vinyldiphenyl(tert-butylperoxy)silane, and

(d) diphenyl(α,α'-dimethylbenzylperoxy)silane.

As sensitizers, employed were (A) naphthacene, (B) benzophenone, (C) benzoin isopropyl ether and (D) 2,4-dimethylthioxantone.

By use of the above, the epoxy resin compositions were prepared in the combinations and the amounts (grams) as shown in the Table 5.

(Encapsulation of light-emitting element)

Each of the photocurable epoxy resin type compositions was poured into a transparent mold, into which a light-emitting element was inserted, and then irradiation with light was made for one minute. A product thus formed was taken out of the mold to obtain a resin encapsulation type light-emitting device. As the light source, employed were two sets of high pressure mercury-vapor lamps of 2 KW each, and the irradiation was made at a position 10 cm distant from the light source.

Continuous energizing tests were carried out for the resin encapsulation type light-emitting devices thus manufactured to obtain the results shown also in Table 5. In the continuous energizing tests, observed were rates of changes in photo-output $P_o$, namely, the deteriorations of photo-output $P_o$, under the conditions $I_F$ 40 mA, 25°C, after 110 Hr.

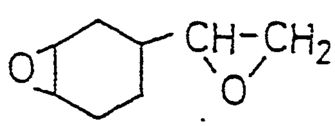

... ... ... (I)

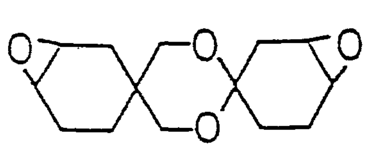

... ... ... (II)

BAD ORIGINAL

Table 5

| Components et al. | Example No. 5 | 6 | 7 | 8 | 9 | 10 | 11 | 12 | 13 | 14 | 15 | 16 |
|---|---|---|---|---|---|---|---|---|---|---|---|---|
| Epoxy resins: | | | | | | | | | | | | |
| ERL-4221 | 100 | 70 | 50 | 40 | 50 | 30 | 50 | 70 | 40 | 50 | 50 | 50 |
| Chissonox 206 | - | - | 30 | - | - | 30 | - | - | - | - | - | - |
| " 234 | - | - | - | 40 | - | - | 10 | - | - | - | - | - |
| Epikote 828 | - | 30 | - | - | 40 | - | - | - | - | - | - | - |
| " 1001 | - | - | 20 | - | - | 25 | - | 10 | - | - | - | - |
| " 1004 | - | - | - | 20 | - | - | 20 | - | 10 | - | 10 | 10 |
| Phenol seriese compound (1) | - | - | - | - | 10 | - | - | - | - | 10 | - | - |
| " (2) | - | - | - | - | - | 15 | - | - | - | 5 | - | - |
| Ethylenic compound (3) | - | - | - | - | - | - | 20 | - | - | - | - | - |
| " (4) | - | - | - | - | - | - | - | 20 | 5 | - | - | 10 |
| Acid anhydride (5) | - | - | - | - | - | - | - | - | 40 | - | - | - |
| " (6) | - | - | - | - | - | - | - | - | - | 40 | - | 30 |
| " (7) | - | - | - | - | - | - | - | - | - | - | 40 | - |
| Aluminum compounds: | | | | | | | | | | | | |
| (i) | 0.5 | 0.5 | - | - | - | - | - | - | - | 0.5 | - | - |
| (ii) | - | - | 0.5 | - | 0.5 | - | - | - | 0.5 | - | - | - |
| (iii) | - | - | - | 1 | - | - | - | 1 | - | - | - | - |
| (iv) | - | - | - | - | - | 0.5 | - | - | - | - | 0.5 | 0.5 |
| (v) | - | - | - | - | - | - | 0.5 | - | - | - | - | - |

BAD ORIGINAL

Table 5 (cont'd)

| Components et al. | Example No. 5 | 6 | 7 | 8 | 9 | 10 | 11 | 12 | 13 | 14 | 15 | 16 |
|---|---|---|---|---|---|---|---|---|---|---|---|---|
| Silicon compounds: | | | | | | | | | | | | |
| (a) | 1 | 1.5 | - | - | - | - | - | 1 | - | - | - | - |
| (b) | - | - | 1.5 | - | - | 1.5 | - | - | - | 2 | - | - |
| (c) | - | - | - | 1.5 | - | - | 1.5 | - | - | - | - | 1.5 |
| (d) | - | - | - | - | 2 | - | - | - | 1.5 | - | 2 | - |
| Photo-sensitizer: | | | | | | | | | | | | |
| (A) | 1.0 | - | - | - | - | - | - | - | - | 1.5 | - | - |
| (B) | - | 1.5 | - | - | - | - | 1.5 | - | 2.0 | - | - | - |
| (C) | - | - | 1.0 | - | 1.5 | - | - | 2.0 | - | - | 2.0 | - |
| (D) | - | - | - | 1.0 | - | 1.5 | - | - | - | - | - | 1.5 |
| $P_o$ deterioration (%) | 35 | 42 | 40 | 38 | 57 | 41 | 55 | 58 | 38 | 39 | 45 | 47 |
| Appearance | x | x | x | x | Y | Y | Y | x | x | x | x | x |

(x: colorless, transparent; Y: pale yellow, transparent)

Example 17

(Preparation of resin composition)

| | |
|---|---|
| ERL 4221 (trademark, produced by Union Carbide Corp., an alicylic epoxy resin, epoxy equivalent: 145) | 300 g |
| Hexahydrophthalic anhydride | 150 g |
| Trisethylacetoacetonatoaluminum | 2 g |
| Trisphenylsilyl phenyl ketone | 6 g |
| Benzophenone | 2 g |
| Isopropyl alcohol | 3 g |

BAD ORIGINAL

A composition of the above combination was stirred and mixed at 60°C to obtain a resin composition for encapsulation.

(Manufacture of light-emitting device)

The resin composition thus prepared was poured into a transparent container, into which a light-emitting element was inserted until it was buried at a predetermined position. Thereafter, irradiation with UV ray was made for 3 minutes by use of two sets of metal halide lamps of 80 W/cm each. Performances of a resin encapsulation type light-emitting device thus manufactured are shown in Table 6.

Table 6

| | | |
|---|---|---|
| Appearance | : | extremely colorless and transparent |
| Water resistance | : | no change in appearance, such as color change, at 90°C, 90% RH, after 1000 Hr; no change in brightness. |
| Heat resistance | : | no change in appearance, such as color change, at 120°C, after 1000 Hr. |

Examples 18 to 28

Resin encapsulation type light-emitting devices were manufactured in the same manner as in Example 17 by using epoxy resins, aluminum compounds and α-ketosilyl compounds as shown in Table 7. Additives, when used additionally, are also shown therein. In the Table, also shown is the time during which the irradiation with light was performed until the resins cured. Continuous energizing tests were also carried out in the same manner as in Example 5 to 16. Results are shown in Table 7.

BAD ORIGINAL

Table 7

| Example No. | Epoxy resins (g) | Aluminum compounds (g) | α-ketosilyl compounds (g) | Additives (g) | Irradiation time (min.) | $P_o$ deterioration (%) |
|---|---|---|---|---|---|---|
| 18 | ERL-4221 100 g | trissalicylaldehydatoaluminum 1 g | triphenylsilyl phenyl ketone 2 g | - | 40 | 35 |
| 19 | ERL-4221 100 g | trisethylacetoacetatoaluminum 0.5 g | diphenylmethylsilyl phenyl ketone 1 g | 2,4-dimethylbenzophenone 1 g | 20 | 30 |
| 20 | ERL-4221 100 g hexahydrophthalic anhidride 80 g | trisethylacetoacetatoaluminum 0.5 g | triphenylsilyl phenyl ketone 2 g | - | 50 | 38 |
| 21 | ERL-4221 100 g methylhexahydrophthalic anhidride 80 g | trissalicylaldehydatoaluminum 1 g | diphenylvinylsilyl phenyl ketone 1 g | thioxanthone 1 g | 30 | 37 |
| 22 | ERL-4221 50 g Epikote 828 50 g | trisethylacetoacetatoaluninum 0.5 g | triphenylsilyl-4-methoxyphenyl ketone 5 g | isopropyl alcohol 1 g | 20 | 35 |
| 23 | ERL-4221 100 g methylhexahydrophthalic anhidride, 80 g | trissalicylaldehydatoaluminum 0.5 g | diphenylmethylsilyl phenyl ketone 2 g | isopropyl alcohol 1 g | 30 | 30 |

BAD ORIGINAL

Table 7 (Cont'd)

| Example No. | Epoxy resins (g) | Aluminum compounds (g) | α-ketosilyl compounds (g) | Additives (g) | Irradiation time (min.) | $P_o$ deterioration (%) |
|---|---|---|---|---|---|---|
| 24 | ERL-4221 100 g | trisethylacetoacetatoaluminum 0.5 g | triphenylsilyl phenyl ketone 1 g | benzophenone 1 g<br>isopropyl alcohol 1 g | 5 | 35 |
| 25 | ERL-4221 100 g<br>methyltetrahydrophthalic anhidride 50 g | trissalicylaldehydatoaluminum 1 g | triphenylsilyl phenyl ketone 1 g | ethyl o-benzoilbenzoate 1 g<br>isopropyl alcohol 1 g | 5 | 32 |
| 26 | Epikote 828 100 g<br>methylhexahydrophthalic anhidride 80 g | trissalicylaldehydatoaluminum 5 g | triphenylsilyl phenyl ketone 5 g | thioxanthone 1 g<br>isopropyl alcohol 1 g | 60 | 35 |
| 27 | ERL-4221 100 g<br>diethylene glycol diacryrate 20 g | trisethylacetoacetatoaluminum 1 g | triphenylsilyl phenyl ketone 2 g | - | 30 | 30 |
| 28 | ERL-4221 100 g<br>dipenthaerithritol hexacrylate 20 g | trissalicylaldehydatoaluminum 1 g | triphenylsilyl phenyl ketone 2 g | benzophenone 1 g<br>isopropyl alcohol 1 g | 5 | 32 |

BAD ORIGINAL

Example 29

(Preparation of resin composition)

| | |
|---|---|
| ERL-4221 (trademark, produced by Union Carbide Corp., an alicyclic epoxy resin, epoxy equivalent: 145) | 400 g |
| Epikote 1004 (trademark, produced by Shell International Chemicals Corp., a bisphenol type epoxy resin, epoxy equivalent: 900 to 1,000, molecular weight: about 1,400) | 100 g |
| Trisethylacetoacetonatoaluminum | 1 g |
| Diphenyldi(nitrobenzyloxy)silane | 5 g |

A composition of the above combination was stirred under heating at 150°C for 10 minutes to obtain a resin composition for encapsulation.

(Encapsulation of light-emitting element)

Dipped into the resin composition thus prepared was a light-emitting element, which was then pulled out and subjected to irradiation with light for one minutes. Employed as the light source were two sets of metal halide lamps of 80 W/cm each, which were positioned 10 cm distant from the light-emitting element. Performances of a resin encapsulation type light-emitting device thus manufactured were tested to obtain the results shown in Table 8.

BAD ORIGINAL

Table 8

| | |
|---|---|
| Appearance | : pale yellow, transparent |
| Water resistance | : no deterioration of photo-output $P_o$ at 90°C, 90% RH, after 2000 Hr. |
| Heat resistance | : no deterioration of photo-output $P_o$ at 120°C, after 1000 Hr. |
| Soldering resistance | : no cracks appeared when immersed into a soldering bath of 300°C. |
| Continuous energizing test: | deterioration of $P_o$ under conditions of $I_F$ = 40 mA, 25°C, after 110 Hr: 30% |

Example 30

(Preparation of resin composition)

| | |
|---|---|
| Epikote 828 (trademark, produced by Shell International Chemicals Corp., a bisphenol type epoxy resin, epoxy equivalent: 190 to 210, molecular weight: 380) | 250 g |
| ERL 4221 | 250 g |
| Trissalicylaldehydatoaluminum | 0.5 g |
| Triphenyl(o-nitrobenzyloxy)silane, | 10 g |

A composition of the above combination was stirred and mixed under heating at 60°C for 10 minutes to obtain a resin composition for encapsulation.

(Encapsulation of light-emitting element)

The resin composition thus prepared was poured into a transparent container, into which a light-emitting element was inserted until it was buried at a

BAD ORIGINAL

predetermined position. Thereafter, irradiation with light was made for 3 minutes in the same manner as in Example 29. Performances of a resin encapsulation type light-emitting device thus manufactured were tested to obtain the results shown in Table 9.

Table 9

| | |
|---|---|
| Appearance | : pale yellow, transparent |
| Water resistance | : no deterioration of photo-output $P_o$ at 90°C, 90% RH, after 2000 Hr. |
| Heat resistance | : no deterioration of photo-output $P_o$ at 120°C, after 1000 Hr. |
| Continuous energizing test: | deterioration of $P_o$ under conditions of $I_F$ = 40 mA, 25°C, after 110 Hr.: 35% |

Example 31

(Preparation of resin composition)

| | |
|---|---|
| ERL 4221 | 200 g |
| Hexahydrophthalic anhydride | 160 g |
| Trisethylacetoacetonatoaluminum | 1.0 g |
| Diphenyldi(o-nitrobenzyloxy)silane, | 5 g |

The above composition was stirred under heating at 60°C for 30 minutes to prepare a resin composition for encapsulation.

(Encapsulation of light-emitting element)

The resin composition for encapsulation thus prepared was poured into a metallic mold, into which a light-emitting element was inserted and irradiation with light was made

BAD ORIGINAL

for one minute. Employed as the light source was two sets of metal halide lamps of 80 W/cm each, which were positioned 10 cm distant from the mold. During the irradiation for one minute, curing reaction proceeded to the extent that the molded product slips out of the mold. After taking it out of the mold, further irradiation with light was made for one minute before it has cured completely. Performances of a resin encapsulation type light-emitting device thus manufactured were tested to obtain the results shown in Table 10.

Table 10

| | |
|---|---|
| Appearance : | colorless, transparent |
| Water resistance : | no change in appearance, such as color change, at 90°C, 90% RH, after 2000 Hr; no change in brightness |
| Heat resistance : | no change in appearance, such as color change, at 120°C, after 1000 Hr; no change in brightness |
| Continuous energizing test: | deterioration of $P_o$ under conditions of IF = 40 mA, 25°C, after 110 Hr.: 40% |

Examples 32 to 42

Resin encapsulation type light-emitting devices were manufactured in the same manner as in Example 29, by using resin composition made of epoxy resins, aluminum compounds and organic silicon compounds as shown in Table 11. Additives, when used additionally, are also shown therein. In the Table, also shown is the time during which the irradiation with light was performed until the resins cured. Continuous energizing tests were also carried out in the same manner as in the previous Examples. Results are shown in Table 11.

Table 11

| Example No. | Epoxy resins (g) | Aluminum compounds (g) | Organic silicon compounds (g) | Additives (g) | Irradiation time (min.) | $P_o$ deterioration (%) |
|---|---|---|---|---|---|---|
| 32 | ERL-4221 50 g Epikote 828 50 g | trisethylaceto-acetatoaluminum 0.5 g | triphenyl(o-nitrobenzyl-oxy)silane 3 g | - | 1 | 35 |
| 33 | ERL-4221 50 g Epikote 1004 50 g | trisacetyl-acetonatoaluminum 1 g | triphenyl( -ethyl-o-nitro-benzyloxy)silane 2 g | silica powder 5 g | 3 | 37 |
| 34 | ERL-4221 50 g Epikote 1004 50 g | trisacetyl-acetonatoaluminum 1 g | triphenyl(4,5,6-trimethoxy-2-nitrobenzyloxy)-silane 1 g | - | 3 | 33 |
| 35 | ERL-4221 50 g Epikote 828 50 g | trissalicylalde-hydatoaluminum 0.5 g | triphenyl(4,5-dimethyl-2-nitro-benzyloxy)silane 1 g | - | 1 | 38 |
| 36 | ERL-4221 50 g Epikote 828 50 g | trisethylaceto-acetatoaluminum 0.5 g | triphenyl(3-methoxy-2-nitro-benzyloxy)silane 1 g | white carbon 3 g | 3 | 34 |
| 37 | ERL-4221 50 g Epikote 1004 50 g | trissalicylalde-hydatoaluminum 0.5 g | diphenylmethyl(5-methoxy-2-nitro-benzyloxy)silane 1 g | - | 1 | 32 |

Table 11 (Cont'd)

| Example No. | Epoxy resins (g) | Aluminum compounds (g) | Organic silicon compounds (g) | Additives (g) | Irradiation time (min.) | $P_o$ deterioration (%) |
|---|---|---|---|---|---|---|
| 38 | ERL-4221 50 g<br>Epikote 828 70 g | trissalicylaldehydatoaluminum 1 g | vinylphenyl(o-nitrobenzyloxy)-silane 1 g | - | 3 | 35 |
| 39 | ERL-4221 40 g<br>Epikote 828 60 g | trisethylacetoacetatoaluminum 1 g | t-butylphenyl(o-nitrobenzyloxy)-silane 1 g | - | 2 | 33 |
| 40 | ERL-4221 90 g<br>Epikote 1004 10 g | trisethylacetoacetatoaluminum 0.5 g | diphenyldi(o-nitrobenzyloxy)-silane 1 g | - | 1 | 32 |
| 41 | ERL-4221 85 g<br>Epikote 1004 15 g | trisethylacetoacetatoaluminum 0.5 g | diphenyldi(3-methoxy-2-nitrobenzyloxy)silane 1 g | - | 1 | 35 |
| 42 | ERL-4221 70 g<br>Epikote 1004 30 g | trisethylacetoacetatoaluminum 0.5 g | triphenyl(o-nitrobenzyloxy)silane 0.5 g<br>diphenyldi(o-nitrobenzyloxy)silane 0.5 g | - | 1 | 30 |

Examples 43 to 48

Six kinds of photocurable epoxy resin compositions were prepared by using as resins ERL 4221 (trademark, produced by Union Carbide Corp., an alicyclic epoxy resin, epoxy equivalent: 137), ERL 4299 (trademark, produced by Union Carbide Corp., an alicyclic epoxy resin, epoxy equivalent: 200), Epikote 828 (trademark, produced by Shell International Chemicals Corp., a bisphenol A type epoxy resin, epoxy equivalent: 190) and Epikote 1001 (trademark, produced by Shell International Chemicals Corp., a bisphenol A type epoxy resin, epoxy equivalent: 450); as aluminum compounds, trisacetylacetonatoaluminum (TAAA), trisethylacetoacetatoaluminum (TEAACA) and trissalicylaldehydatoaluminum (TSADA); and as silicon compounds, tert-butylperoxytriphenylsilane (TBTPS), cumyl peroxytriphenylsilane (CTPS) and tert-butylperoxy-diphenylsilane (TBDPS), which were selected to have the compositional proportions (parts by weight) as shown in Table 12.

For comparison, a control resin composition was prepared by reacting 280 g of Epikote 828 and 110 g of acrylic acid at 120 to 125°C for 18 hours in the presence of 0.5 g each of hydroquinone and triethylenediamine to synthesize a UV ray-curable resin, followed by mixing of 10 g of benzophenone and 175 g of pentaerithritol triacrylate into 200 g of the resin under heating at 80 to 85°C to make a homogeneous mixture. This was designated as a Comparative Example.

The resin compositions thus prepared in Examples 43 to 48 and Comparative Example were poured into ceramic containers equipped with photoelectric transducers (CCD image sensors), which were then irradiated with light for 3 minutes. Employed as light source were two sets of metal halide lamps of 2 KW each, and irradiation was carried out at a position 10 cm distant from the light

0114258

source. Resin encapsulation type photoelectric transducers thus manufactured were subjected to tests allowing them to stand at high temperature and high humidity in an atmosphere of 60°C and 90% RH. Results are shown together in Table 12. The high temperature and high humidity tests were carried out by measuring photo-actuation performances with lapse of time.

Table 12

| Components et al | | Examples 43 | 44 | 45 | 46 | 47 | 48 | Comparative example |
|---|---|---|---|---|---|---|---|---|
| Epoxy resins: | | | | | | | | |
| ERL 4221 | | 70 | 100 | 70 | 70 | 50 | 60 | |
| ERL 4299 | | - | - | - | 30 | - | - | |
| Epikote 828 | | 30 | - | - | - | 50 | 20 | |
| Epikote 1001 | | - | - | 30 | - | - | 20 | |
| Aluminum compounds: | | | | | | | | |
| TAAA | | 0.5 | - | - | - | 1 | 0.4 | |
| TEAACA | | - | 0.5 | - | 0.5 | - | - | |
| TSADA | | - | - | 0.5 | - | - | 0.2 | |
| Silicon compounds: | | | | | | | | |
| TBTPS | | 2 | - | - | 2 | - | - | |
| CTPS | | - | 2 | - | - | 2 | 3 | |
| TBDPS | | - | - | 2 | - | - | - | |
| Accumulative deterioration percentages in high temp.-high humid. tests | 250 H | 0 | 0 | 0 | 0 | 0 | 0 | 12 |
| | 500 H | 0 | 0 | 0 | 0 | 0 | 0 | 38 |
| | 750 H | 0 | 0 | 0 | 0 | 0 | 0 | 93 |
| | 1000 H | 0 | 1 | 0 | 0 | 1 | 0 | 200 |
| Appearance | | x | x | Y | x | x | x | Y |

(x: colorless, transparent; Y: pale yellow, transparent)

Examples 49 to 54

Six kinds of photocurable epoxy resin compositions were prepared by using as resins ERL 4221, Epikote 828 and Epikote 1001 used in Examples 43 to 48 and Epikote 1004 (trademark, produced by Shell International Chemicals Corp., a bisphenol A type epoxy resin, epoxy equivalent: 950); as aluminum compounds, trisacetylacetonatoaluminum (TAAA), trispropylacetoacetatoaluminum (TPAACA) and tris-n-butylacetoacetatoaluminum (TNBAACA); and as silicon compounds, triphenyl(o-nitrobenzyloxy)silane, (TPONBS), diphenyldi(o-nitrobenzyloxy)silane (DPONBS), and triphenyl(2,6-dinitrobenzyloxy)silane (TPDNBS), which were selected to have the compositional proportions (parts by weight) as shown in Table 13.

In the same manner as in Examples 43 to 48, photoelectric transdusers (CCD image sensors) were encapsulatted by use of the resin compositions thus prepared to manufacture resin encapsulation type photoelectric transducers. The photoelectric transducers thus manufactured were subjected to continuous energizing tests in which a voltage of 15 V was applied to in an atmosphere of 40°C and 90% RH to measure the photo-actuation performances with lapse of time. Results are shown together in Table 13.

For comparison, also used was a device same with the comparative example mentioned in Examples 43 to 48.

Table 13

| Components et al | | Examples 49 | 50 | 51 | 52 | 53 | 54 | Comparative example |
|---|---|---|---|---|---|---|---|---|
| Epoxy resins: | | | | | | | | |
| ERL 4221 | | 70 | 100 | 70 | 60 | 50 | 40 | |
| Epikote 828 | | - | - | - | 40 | - | 40 | |
| Epikote 1001 | | 30 | - | - | - | 50 | 20 | |
| Epikote 1004 | | - | - | 30 | - | - | - | |
| Aluminum compounds: | | | | | | | | |
| TAAA | | 0.5 | - | - | 0.6 | - | 0.3 | |
| TPAACA | | - | 0.5 | - | - | - | 0.2 | |
| TNBAACA | | - | - | 0.5 | - | 0.4 | - | |
| Silicon compounds: | | | | | | | | |
| TPONBS | | 2 | - | - | - | 3 | - | |
| DPONBS | | - | 2 | - | 2 | - | - | |
| TPDNBS | | - | - | 2 | - | - | 2 | |
| Accumulative deterioration percentages in continuous energizing tests | 250 H | 0 | 0 | 0 | 0 | 0 | 0 | 30 |
| | 500 H | 0 | 0 | 0 | 0 | 0 | 0 | 75 |
| | 750 H | 0 | 0 | 0 | 0 | 0 | 0 | 100 |
| | 1000 H | 1 | 2 | 1 | 0 | 2 | 1 | - |
| Appearance | | x | Y | Y | x | x | x | Y |

(x: colorless, transparent; Y: pale yellow, transparent)

Examples 55 to 60

Six kinds of photocurable epoxy resin compositions were prepared by using as resins ERL 4221, Epikote 828, Epikote 1001 and Epikote 1004; as aluminum compounds, tris-n-butylacetoacetatoaluminum (TNBAACA), trisethylacetoacetatoaluminum (TEAACA) and trissalicylaldehydatoaluminum (TSADA); as silicon compounds, triphenylbenzoilsilane (TPBS) and diphenyl-methyl-benzoilsilane (MDBS), which were selected to have the compositional proportions (parts by weight) as shown in Table 14.

Dipped into the resin compositions thus prepared were phototransistors, which were then pulled out and subjected to irradiation with light for 2 minutes. Employed as light source were two sets of high pressure mercury-vapor lamps of 2 KW each, and irradiation was made at a position 10 cm distant from the light source. Resin encapsulation type phototransistors thus manufactured were subjected to tests allowing them to stand at high temperature and high humidity in an atmosphere of 85°C and 85% RH, while applying inverse bias voltage of 10 V with lapse of time to measure dark current. Results are shown together in Table 14. For comparison, also used was a phototransistor manufactured by the use of the same resin composition as in the comparative example mentioned in Examples 43 to 48.

Table 14

| Components et al | | Examples 55 | 56 | 57 | 58 | 59 | 60 | Comparative example |
|---|---|---|---|---|---|---|---|---|
| Epoxy resins: | | | | | | | | |
| ERL 4221 | | 80 | 50 | 70 | 40 | 40 | 30 | |
| Epicoat 828 | | - | 50 | - | - | 20 | 70 | |
| Epicoat 1001 | | - | - | 20 | 60 | 40 | - | |
| Epicoat 1004 | | 20 | - | 10 | - | - | - | |
| Aluminum compounds: | | | | | | | | |
| TNBAACA | | 0.6 | - | - | 0.5 | 1 | 0.4 | |
| TEAACA | | - | 0.5 | - | - | - | - | |
| TSADA | | - | - | 0.5 | - | - | 0.2 | |
| Silicon compounds: | | | | | | | | |
| TPBS | | 2 | - | 2 | - | 2 | 2 | |
| MDBS | | - | 3 | - | 3 | 1 | - | |
| Accumulative deterioration percentages in high temp.-high humid. test | 250 H | 0 | 0 | 0 | 0 | 0 | 0 | 22 |
| | 500 H | 0 | 0 | 0 | 0 | 0 | 0 | 58 |
| | 750 H | 0 | 0 | 0 | 0 | 0 | 0 | 95 |
| | 1000 H | 1 | 0 | 3 | 2 | 1 | 1 | 100 |
| Appearance | | x | x | Y | x | x | x | Y |

(x: colorless, transparent; Y: pale yellow, transparent)

As is apparent from the foregoing results, it has been confirmed that the epoxy resin compositions used in manufacturing the resin encapsulation type photo-semiconductor devices of this invention are readily curable in a shorter time by irradiation with light and the photo-semiconductor devices thus manufactured are excellent in transparency. The devices thus manufactured are free from undesirable color changes since the epoxy

resin compositions are not colored by the catalytic component. They are also excellent in water resistance and heat resistance. Moreover, because of the materials curable in a shorter time, energy can be saved and the productivity can be enhanced, thereby producing greater industrial values.

Claims:

1. A resin encapsulation type photo-semiconductor device, which comprises a photo-semiconductor element encapsulated with a photopolymerizable composition comprising an epoxy resin, an aluminum compound and a silicon compound capable of forming a silanol group by irradiation with energy rays.

2. The resin encapsulation type photo-semiconductor device according to Claim 1, wherein the epoxy resin is an epoxy compound or a mixture thereof with at least one selected from the group consisting of an acid anhydried, a phenol series compound and an ethylenic compound.

3. The resin encapsulation type photo-semiconductor device according to Claim 2, wherein the epoxy compound is at least one selected from the group consisting of phenyl glycidyl ether, butyl glycidyl ether, a bisphenol type epoxy resin, a phenol-novolac type epoxy resin, an alicyclic epoxy resin, a hydrogenated bisphenol resin and an aliphatic epoxy resin.

4. The resin encapsulation type photo-semiconductor device according to Claim 3, wherein the epoxy compound is an alicyclic epoxy resin or a bisphenol type epoxy resin.

5. The resin encapsulation type photo-semiconductor device according to Claim 2, wherein the acid anhydride is selected from the group consisting of phthalic anhydride, tetrahydrophthalic anhydride, methyltetrahydrophthalic anhydride, hexahydrophthalic anhydride, methylhexahydrophthalic anhydride, maleic anhydride, trimellitic anhydride and hexachloroendomethylenetetrahydrophthalic anhydride.

6. The resin encapsulation type photo-semiconductor device according to Claim 2, wherein the phenol series compound is selected from the group consisting of phenol, bisphenol A, bisphenol F, bisphenol S and a condensate of phenol, cresol, catechol or bisphenol with formaldehyde.

7. The resin encapsulation type photo-semiconductor device according to Claim 2, wherein the ethylenic ocmpound is selected from the group consisting of ethylene glycol diacrylate, 1,3-dibutanediol dimethacrylate and dipentaerithritol hexaacrylate.

8. The resin encapsulation type photo-semiconductor device according to Claim 1, wherein the aluminum compound is at least one of organic aluminum compounds selected from the group consisting of alkoxyaluminum compounds, acyloxyaluminum compounds and aluminum chelate compounds.

9. The resin encapsulation type photo-semiconductor device according to Claim 8, wherein the aluminum compound is at least one of organic aluminum compounds selected from the gropup consisting of trisacetylacetonatoaluminum, trisethylacetoacetatoaluminum, tris(isopropylacetoacetato)aluminum, tris(n-butylacetoacetato)aluminum, trissalycilaldehydato-aluminum and trispropylacetoacetatoaluminum.

10. The resin encapsulation type photo-semiconductor device according to Claim 1, wherein the aluminum compound is mixed in an amount of from 0.001 to 10 % by weight based on the epoxy resin.

11. The resin encapsulation type photo-semiconductor device according to Claim 1, wherein the silicon compound is a silicon compound capable of forming a silanol group by irradiation with light and selected from the group

consisting of i) a silicon compound having a peroxysilyl group, ii) a silicon compound having an α-ketosilyl group or iii) a silicon compound having an o-nitrobenzyloxy group.

12. The resin encapsulation type photo-semiconductor device according to Claim 11, wherein the silicon compound i) is a compound represented by the following formula:

$$(R^1)_n - Si \leftarrow O - O - R^2)_{4-n}$$

(wherein $R^1$ represents a hydrogen atom, a halogen atom, an alkyl group having 1 to 5 carbon atoms, an alkoxy group having 1 to 5 carbon atoms or an aryl group; $R^2$ represents a hydrogen atom, an alkyl group having 1 to 10 carbon atoms or an aryl group; and n is an integer of 0 to 3).

13. The resin encapsulation type photo-semiconductor device according to Claim 12, wherein wherein $R^1$ represents an alkyl group having 1 to 5 carbon atoms, an alkoxy group having 1 to 5 carbon atoms or an aryl group; $R^2$ represents a hydrogen atom, an alkyl group having 1 to 10 carbon atoms or an aryl group; and n is an integer of 0 to 3.

14. The resin encapsulation type photo-semiconductor device according to Claim 13, wherein the silicon compound is selected from the group consisting of diphenyldi(tert-butylperoxy)silane, triphenyl(tert-butylperoxy)silane, triphenyl(α,α-benzylperoxy)silane, triphenyl(α,α'-dimethylbenzylperoxy)silane, vinyldiphenyl(tert-butylperoxy)silane and diphenyl(α,α'-dimethylbenzylperoxy)silane.

15. The resin encapsulation type photo-semiconductor device according to Claim 11, wherein the silicon

BAD ORIGINAL

compound i) is mixed in an amount of from 0.01 to 20 % by weight based on the epoxy resin.

16. The resin encapsulation type photo-semiconductor device according to Claim 11, wherein the silicon compound ii) is a compound represented by the following formula:

$$(R)_n - Si \left( \overset{\overset{O}{\|}}{C} - R \right)_{4-n}$$

(wherein n represents an integer of 0, 1, 2 or 3; and R represents a hydrocarbon group such as an alkyl group or an aromatic group, which groups, however, may have a substituent or substituents such as a halogen, $NO_2$, CN, or $-OCH_3$).

17. The resin encapsulation type photo-semiconductor device according to Claim 16, wherein the silicon compound is selected from the group consisting of triphenylsilyl phenyl ketone, diphenylmethylsilyl phenyl ketone and triphenylvinylsilyl phenyl ketone .

18. The resin encapsulation type photo-semiconductor device according to Claim 11, wherein the silicon compound ii) is mixed in an amount of from 0.1 to 10 % by weight based on the epoxy resin.

19. The resin encapsulation type photo-semiconductor device according to Claim 11, wherein the silicon compound iii) is a compound represented by the following formula:

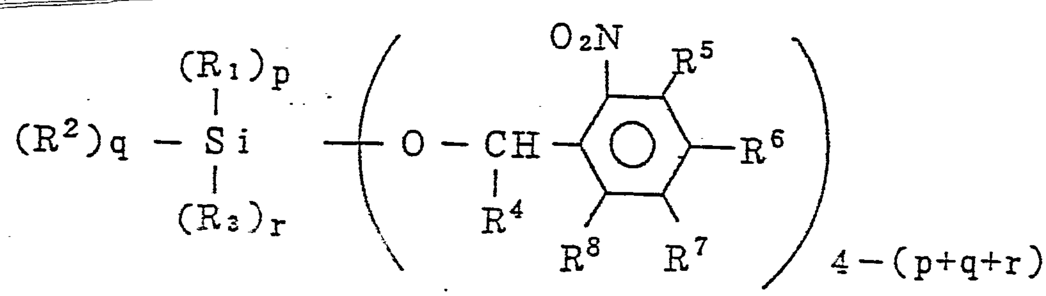

BAD ORIGINAL

(wherein $R^1$, $R^2$ and $R^3$ may be same or different and each represent a hydrogen atom, a halogen atom, a vinyl group, an allyl group, a substituted or unsubstituted alkyl group having 1 to 10 carbon atoms, an alkoxy group having 1 to 10 carbon atoms, a substituted or unsubstituted aryl group, an aryloxy group or a siloxy group; $R^4$ represents a hydrogen atom, a substituted or unsubstituted alkyl group having 1 to 10 carbon atoms or a substituted or unsubstituted phenyl group; $R^5$ to $R^8$ may be same or different and each represent a hydrogen atom, a nitro group, a cyano group, a hydroxyl group, a mercapto group, a halogen atom, an acetyl group, an allyl group, a substituted or unsubstituted alkyl group having 1 to 5 carbon atoms, an alkoxy group having 1 to 5 carbon atoms, a substituted or unsubstituted aryl group or an aryloxy group; and p, q and r are integers satisfying the conditions of $0 \leq p, q, r \leq 3$ and $1 \leq p + q + r \leq 3$); or a compound having as a terminal group an o-nitrobenzyloxysilyl group and as a principal chain a group represented by the formula:

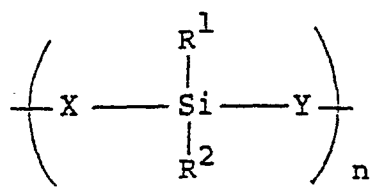

(wherein $R^1$ and $R^2$ are as defined in the above; X and Y may be same or different and each represent an oxygen atom, an alkylene group or an aryl group, and n is an integer of 0 or 1 to 100).

BAD ORIGINAL

20. The resin encapsulation type photo-semiconductor device according to Claim 19, wherein $R^1$, $R^2$ and $R^3$ may be same or different and each represent a hydrogen atom, a vinyl group, an allyl group, a substituted or unsubstituted alkyl group having 1 to 10 carbon atoms, an alkoxy group having 1 to 10 carbon atoms, a substituted or unsubstituted aryl group, an aryloxy group or a siloxy group; $R^4$ represents a hydrogen atom, a substituted or unsubstituted alkyl group having 1 to 10 carbon atoms or a substituted phenyl group; $R^5$ to $R^8$ may be same or different and each represent a hydrogen atom, a nitro group, a cyano group, a hydroxyl group, a halogen atom, a substituted or unsubstituted alkyl group having 1 to 5 carbon atoms, an alkoxy group having 1 to 5 carbon atoms, a substituted or unsubstituted aryl group or an aryloxy group; and p, q and r are integers satisfying the conditions of $0 \leq p, q, r \leq 3$ and $1 \leq p + q + r \leq 3$.

21. The resin encapsulation type photo-semiconductor device according to Claim 19, wherein the compound is selceted from the group consisting of diphenyldi(o-nitrobenzyloxy)silane, triphenyl(o-nitrobenzyloxy)silane, triphenyl(α-ethyl-o-nitrobenzyloxy)silane, triphenyl(4,5,6-trimethoxy-2-nitrobenzyloxy)silane, triphenyl(4,5-dimethyl-2-nitrobenzyloxy)silane, triphenyl(3-methoxy-2-nitrobenzyloxy)silane, diphenylmenty(5-methoxy-2-nitrobenzyloxy)silane, vinylphenyl(o-nitrobenzyloxy)silane, t-butylphenyl(o-nitrobenzyloxy)silane and diphenyldi(3-methoxy-2-nitrobenzyloxy)silane.

22. The resin encapsulation type photo-semiconductor device according to Claim 11, wherein at least one of the compound iii) is mixed in an amount of from 0.001 to 10 % by weight based on the epoxy resin.

23. The resin encapsulation type photo-semiconductor device according to Claim 1, wherein the photopolymerizable composition further comprises a photosensitizer.

24. The resin encapsulation type photo-semiconductor device according to Claim 23, wherein the photosensitizer is at least one selected from the group consisting of benzophenone and derivatives thereof, esters of o-benzoylbenzoic acids, acetophenone and derivatives thereof, benzoin and benzoin ethers and derivatives thereof, xanthone and derivatives thereof, thioxanthone and derivatives thereof and quinone compounds.

25. The resin encapsulation type photo-semiconductor device according to Claim 24, wherein the photosensitizer is at least one selected from the group consisting of naphthacene, benzophenone, 2,4-dimethylbenzophenone, ethyl o-benzoilbenzoate, benzoin isopropyl ether, thioxanthone, and 2,4-dimethylthioxanthone.

26. The resin encapsulation type photo-semiconductor device according to Claim 23, wherein the photosensitizer is mixed in an amount of from 0.001 to 10 % by weight based on the epoxy resin.

European Patent Office

# EUROPEAN SEARCH REPORT

0114258
Application number

EP 83 11 1955

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| A | EP-A-0 041 662 (TOKYO SHIBAURA DENKI K.K.)<br>* Claims 1, 10-13 * | 1-3,8,9 | H 01 L 23/30<br>H 01 L 31/02<br>C 08 L 63/00 |
| A | DE-A-3 013 470 (PLASKON PRODUCTS)<br>* Claim 15 * | 1-3 | |
| A | DE-A-2 908 485 (LICENTIA PATENT-VERWALTUNGS-GMBH)<br>* Claim 1 * | 1 | |
| | | | TECHNICAL FIELDS SEARCHED (Int. Cl. 3) |
| | | | H 01 L 21/56<br>H 01 L 23/30<br>H 01 L 31/02<br>C 08 L 63/00 |

The present search report has been drawn up for all claims

| Place of search | Date of completion of the search | Examiner |
|---|---|---|
| BERLIN | 23-02-1984 | ROTHER A H J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82